# EUROPEAN PATENT APPLICATION

(11) **EP 4 653 888 A1**
(43) Date of publication of application: **26.11.2025**
(21) Application number: 24849597.0
(22) Date of filing: 31.07.2024
(51) Int. Cl.: G01R 31/367, G01R 31/396, H01M 10/42, H02J 3/36, G06F 8/65, G06F 8/61

(54) **BATTERY SYSTEM AND OPERATING METHOD THEREOF**

(30) Priority: 02.08.2023 KR 20230101048
(71) Applicant: LG Energy Solution, Ltd., Seoul 07335 (KR)
(72) Inventor: OH, Seung Take, Daejeon 34122 (KR)
(74) Representative: Plasseraud IP
(86) International application number: PCT/KR2024/011206
(87) International publication number: WO 2025/029030

(57) **Abstract**

A battery system and a method of operating the same according to the exemplary embodiments of the present invention recognize and execute updated control logic from a control logic generating device by a virtual machine in real time to enable execution of the updated control logic without interrupting a battery management system, thereby providing software capable of performing highly efficient battery management operation.

## Description

### [Technical Field]

This application claims priority to and the benefit of Korean Patent Application No. 10-2023-0101048 filed in the Korean Intellectual Property Office on August 2, 2023, the entire contents of which are incorporated herein by reference.

The present invention relates to a battery system and a method of operating the same, and more particularly, to a battery system and a method of operating the same, which are capable of updating a control program of a battery management device during operation of the battery system, without interruption of battery monitoring.

### [Background Art]

An Energy Storage System (ESS) is a system that combines renewable energy, batteries that store power, and existing system power. In recent years, as smart grids and renewable energy have become more widespread and the efficiency and stability of power systems have been emphasized, energy storage systems are increasingly being demanded to control power supply and demand and improve power quality. Depending on the purpose of use, energy storage systems vary in power output and capacity. To form a large capacity energy storage system, a plurality of battery systems may be interconnected.

For example, an energy storage system applied to a Photo Voltaic (PV) system may include a battery section composed of multiple batteries, a battery management system for battery management, a Power Conversion System (PCS), and an Energy Management System (EMS), and a DC-DC converter.

Among them, the battery management system is the core configuration that manages the battery, and it requires continuous system updates to efficiently manage the battery operating on the site.

In order to update the software, the typical battery management system requires an administrator to visit the site directly, interrupt the operation of the operating battery system, and then update the software.

However, in this case, compensation for the use disruption of the battery management system is essentially required and it is necessary for an administrator to visit the site to update the software, so that time and material costs are incurred, which is inefficient.

### [Detailed Description of the Invention]

### [Technical Problem]

An object of the present invention is to provide a highly efficient battery system to solve the above problems.

Another object of the present invention is to provide a method of operating a highly efficient battery system to solve the above problems.

### [Technical Solution]

An exemplary embodiment of the present invention provides a battery system including a plurality of Battery Management Systems (BMSs) with a hierarchical structure, the battery system including: a plurality of slave BMSs; and a master BMS linked with the plurality of slave BMSs, in which during operation of the battery system, the master BMS identifies a target for application of an externally inputted control program for battery management, and transmits a control program corresponding to the target for application to the target for application.

Herein, when the control program is a control program applied to a slave BMS, the master BMS may compare version information of each of the plurality of slave BMSs with version information of the control program, and determine a specific slave BMS having a lower version than the version information of the control program as the target for application, and transmit the control program to the target for application.

In this case, the master BMS may transmit the control program to the storage space of the target for application.

In the meantime, the specific slave BMS may delete a control program pre-stored in a first region of a memory of the specific slave BMS, and copy a control program stored in a storage space of the specific slave BMS and store the copied control program in a second region of the memory.

In this case, when a re-execution signal is received from the master BMS, the specific slave BMS may copy the control program stored in the second region and store the copied control program in the first region

In the meantime, the plurality of slave BMSs may include at least one first slave BMS and at least one second slave BMS having a hierarchical structure, and the second slave BMS may be a sub-hierarchy of the first slave BMS.

Accordingly, when the control program is a control program applied to the second slave BMS, the master BMS may transmit a control program of the second slave BMS to a storage space of the first slave BMS, and the first slave BMS may transmit the control program of the second slave BMS, which has been transmitted to the storage space of the first slave BMS, to a storage space of the second slave BMS.

Further, when the control program is a control program applied to the second slave BMS, the master BMS may compare version information of at least one control program individually received from the plurality of second slave BMSs with version information of the at least one control program, and determine a specific second slave BMS having a lower version than the version information of the control program as the target for application, and transmit the at least one control program to a storage space of the target for application.

Further, the second slave BMS may delete a control program pre-stored in a first region of a memory of the second slave BMS, copy a control program stored in the storage space of the second slave BMS, and store the copied control program in a second region of the memory.

In this case, when a re-execution signal is received from the master BMS, the second slave BMS may copy the control program stored in the second region and store the copied control program in the first region.

In the meantime, the storage space may include an external memory.

Further, the first region may be an inactive region, and the second region may be an active region.

Another exemplary embodiment of the present invention provides a method of operating a battery system including a plurality of Battery Management Systems (BMSs) with a hierarchical structure, the method including: obtaining, by a master BMS, an externally inputted control program for battery management during operation of the battery system; identifying, by the master BMS, each target for application of the control program; and transmitting, by the master BMS, a control program corresponding to the target for application to the target for application.

Herein, the identifying of, by the master BMS, each target for application of the control program may include: when the control program is a control program applied to a slave BMS, comparing, by the master BMS, version information of each of a plurality of slave BMSs linked with the master BMS with version information of the control program; and determining, by the master BMS, a specific slave BMS having a lower version than the version information of the control program as the target for application.

In this case, the transmitting of, by the master BMS, the control program corresponding to the target for application to the target for application may include transmitting, by the master BMS, the control program to a storage space of the target for application.

Further, the method may further include: when a control program of a specific slave BMS is stored in the storage space, deleting, by the specific slave BMS, a control program pre-stored in a first region of a memory; and copying, by the specific slave BMS, a control program stored in a storage space of the specific slave BMS and storing the copied control program in a second region of the memory.

Further, the method may further include: receiving, by the specific slave BMS, a re-execution signal from the master BMS; copying, by the specific slave BMS, the control program stored in the second region and storing the copied control program in the first region; and re-executing the specific slave BMS.

In the meantime, the plurality of slave BMSs may include at least one first slave BMS and at least one second slave BMS having a hierarchical structure, and the second slave BMS may be a sub-hierarchy of the first slave BMS.

Accordingly, the transmitting of, by the master BMS, the control program corresponding to the target for application to the target for application may include: when the control program is a control program applied to the second slave BMS, transmitting, by the master BMS, a control program of the second slave BMS to a storage space of the first slave BMS; and transmitting, by the first slave BMS, the control program of the second slave BMS, which has been transmitted to the storage space of the first slave BMS, to a storage space of the second slave BMS.

Further, the method may further include: when the control program of the second slave BMS is stored in the storage space, deleting, by the second slave BMS, the control program pre-stored in a first region of a memory; and copying, by the second slave BMS, the control program stored in the storage space of the second slave BMS and storing the copied control program in a second region of the memory.

In this case, the method may further include: when a re-execution signal is received from the master BMS, copying, by the second slave BMS, the control program stored in the second region; and storing, by the second slave BMS, the copied control program in the first region.

### [Advantageous Effects]

The battery system and the method of operating the battery system according to the exemplary embodiments of the present invention are capable of continuously performing battery state monitoring by updating the battery management device without interrupting the operation of the battery.

### [Brief Description of Drawings]

FIG. 1 is a block diagram of an energy storage system to which an exemplary embodiment of the present invention may be applied.
FIG. 2 is a block diagram of a general battery system.
FIG. 3 is a block diagram of a battery system according to an exemplary embodiment of the present invention.
FIG. 4 is a block diagram for illustrating a hardware structure of a BMS in the battery system according to the exemplary embodiment of the present invention.
FIG. 5 is a block diagram for illustrating a memory structure of the BMS in the battery system according to the exemplary embodiment of the present invention.
FIG. 6 is a flowchart for illustrating a method of operating a battery system according to an exemplary embodiment of the present invention.
FIG. 7 is a flowchart for illustrating a method of updating a plurality of first slave BMSs in the battery system according to the exemplary embodiment of the present invention.
FIG. 8 is a flowchart for illustrating a method of updating a plurality of second slave BMSs in the battery system according to the exemplary embodiment of the present invention.

| | | | |
|---|---|---|---|
| 100: | Battery system | 110: | BMS |
| 111: | Master BMS | 112: | First slave BMS |
| 113: | Second slave BMS | 120: | External storage device |
| 130: | Storage space | 410: | Memory |
| 411: | First region | 412: | Second region |
| 420: | Processor | 430: | Transceiving device |
| 440: | Input interface device | 450: | Output interface device |
| 460: | Storage device | 470: | Bus |

### [Best Mode]

The invention is subject to various modifications and may have many exemplary embodiments, and certain exemplary embodiments are illustrated in the drawings and described in more detail in the detailed description. However, it is not intended to limit the present invention to the specific exemplary embodiments, and it will be appreciated that the present invention includes all modifications, equivalences, or substitutions included in the spirit and the technical scope of the present invention. In describing each drawing, like reference numerals in the drawings refer to the same or similar functions.

Terms, such as first, second, A, and B, are used for describing various constituent elements, but the constituent elements are not limited by the terms. The terms are used only to discriminate one constituent element from another constituent element. For example, without departing from the scope of the invention, a first constituent element may be named as a second constituent element, and similarly a second constituent element may be named as a first constituent element. A term "and/or" includes a combination of multiple relevant described items or any one of the multiple relevant described items.

It should be understood that when one constituent element referred to as being "coupled to" or "connected to" another constituent element, one constituent element may be directly coupled to or connected to the other constituent element, but intervening elements may also be present. By contrast, when one constituent element is referred to as being "directly coupled to" or "directly connected to" another constituent element, it should be understood that there are no intervening elements.

Terms used in the present application are used only to describe specific exemplary embodiments, and are not intended to limit the present invention. Singular expressions used herein include plurals expressions unless they have definitely opposite meanings in the context. In the present application, it will be appreciated that terms "including" and "having" are intended to designate the existence of characteristics, numbers, steps, operations, constituent elements, and components described in the specification or a combination thereof, and do not exclude a possibility of the existence or addition of one or more other characteristics, numbers, steps, operations, constituent elements, and components, or a combination thereof in advance.

All terms used herein including technical or scientific terms have the same meanings as meanings which are generally understood by those skilled in the art unless they are differently defined. Terms defined in generally used dictionary shall be construed as having meanings matching those in the context of a related art, and shall not be construed in ideal or excessively formal meanings unless they are clearly defined in the present application

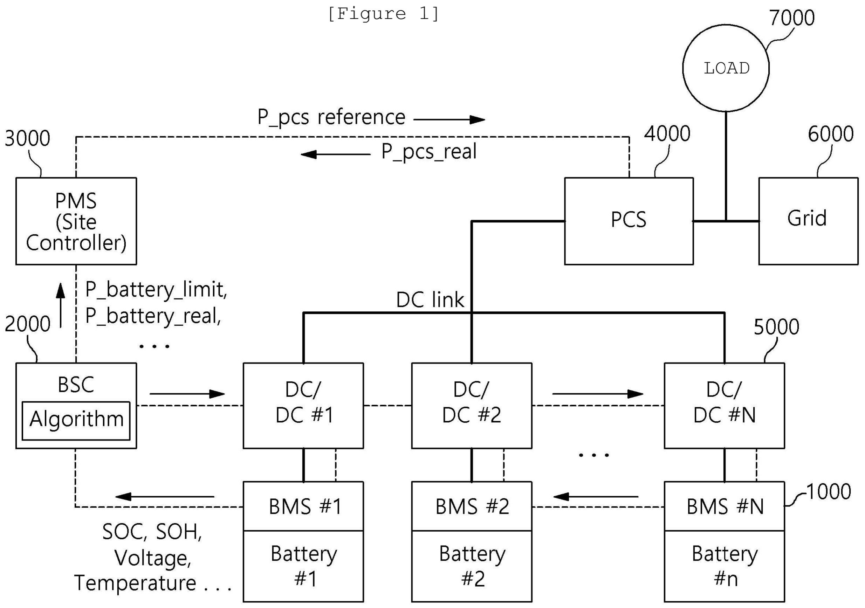

FIG. 1 is a block diagram of an energy storage system to which an exemplary embodiment of the present invention may be applied.

Referring to FIG. 1, a battery that serves to store power in an energy storage system may be typically implemented in the form of a series/parallel combination of battery cells configuring a plurality of battery packs, and the plurality of battery packs configuring a battery rack. Herein, the battery pack may also be referred to as a battery module, depending on the device or system in which the battery is used. For example, Battery #1, Battery #2, ... , Battery #N illustrated in FIG. 1 may be in the form of a battery pack or battery rack.

In this case, in each battery, a Battery Management System (BMS) 100 may be installed.

The BMS 1000, to which the exemplary embodiment of the present invention may be applied, may monitor current, voltage, and temperature of each battery pack (or rack) under its control, calculate a Status Of Charge (SOC) based on the monitoring results, and control charging and discharging.

On the other hand, a Battery System Controller (BSC) may be installed in each of the battery sections including a plurality of batteries and peripheral circuits, devices, and the like. Accordingly, the BSC 2000 may monitor and control targets for control, such as a voltage, current, temperature, and circuit breaker, within the battery section. Further, the BSC 2000 calculates the output of each DC-DC converter 5000 based on status information of the monitored battery terminal and transmits the calculated output of each DC-DC converter 500 to the DC-DC converter.

In addition, a Power Conversion System (PCS) 4000 installed in each battery section may control the charging and discharging of the battery by controlling the power supplied from the outside and the power supplied from the battery section to the outside. For example, the PCS 4000 may include a DC-AC inverter.

Meanwhile, communication may be established between the BMS 1000, the BSC 2000, the PMS 3000, and the PCS 4000 by using a Controller Area Network (CAN) or Ethernet (illustrated as dashed lines in FIG. 1).

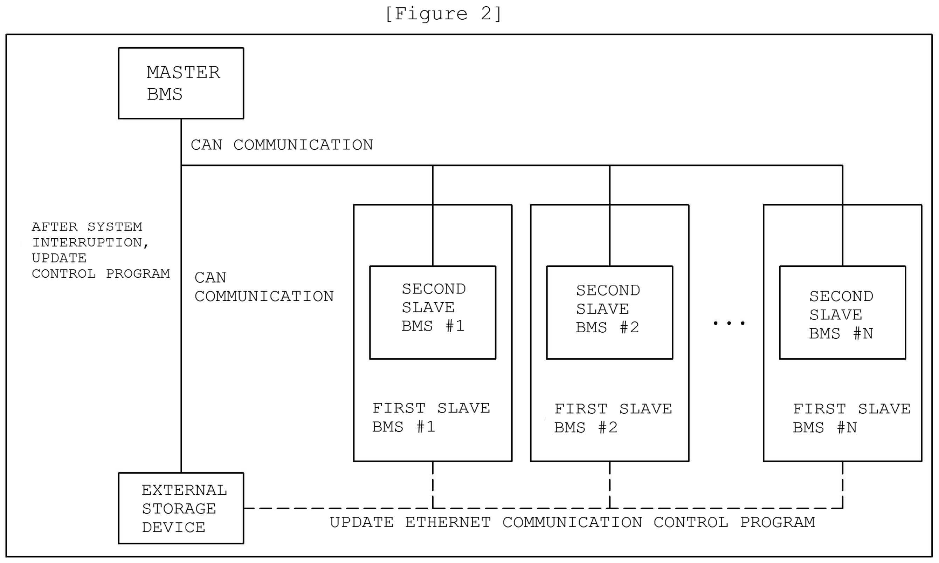

FIG. 2 is a block diagram of a general battery system.

Referring to FIG. 2, a general battery system applied to an Energy Storage System (ESS) includes a plurality of BMSs that manage the batteries according to a hierarchical structure of batteries.

The plurality of BMSs requires continuous updating of the control programs for efficient management for each battery unit. Accordingly, a general battery system obtains a higher version of the control program for at least one control program of the plurality of BMSs from an external storage device and updates the corresponding BMS.

In this case, in order to obtain the higher version of the control program, a re-execution of the corresponding BMS is essentially required. Accordingly, the general battery system individually receives the control program corresponding to the BMSs of the hierarchy to which the BMS belongs from the external storage device and the updates the corresponding BMS, after the system is shut down by the administrator.

Accordingly, the general battery system has the disadvantage that when updating the control program of at least one of the plurality of BMSs to a higher version, the operation of the battery system is necessarily interrupted, making it difficult to monitor the status of the battery.

Accordingly, the present invention describes a battery system in which a control program of at least one of a plurality of BMSs may be updated without interrupting an operation of a battery system.

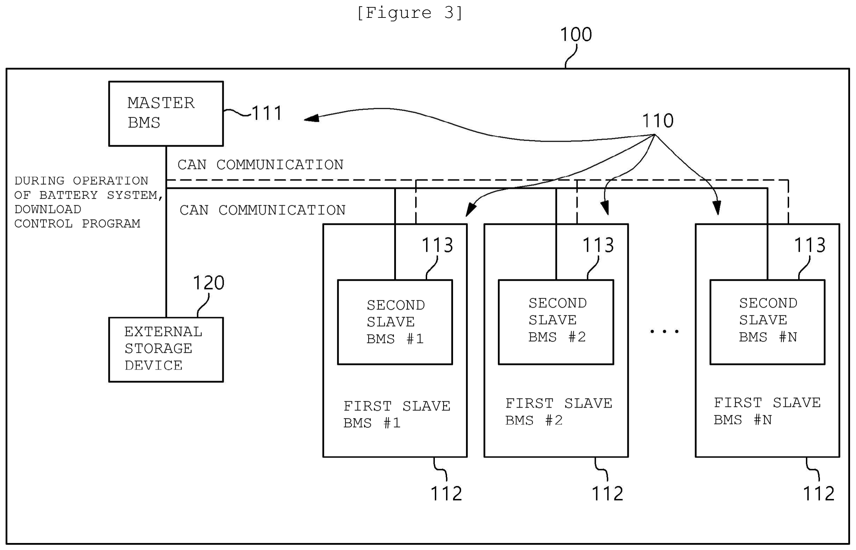

FIG. 3 is a block diagram of a battery system according to an exemplary embodiment of the present invention.

Referring to FIG. 3, a battery system 100 may be applied to an Energy Storage System (ESS). Accordingly, the battery system 100 may manage the status of batteries operating at a site.

More specifically, according to the exemplary embodiment, the battery system 100 may include a plurality of BMSs 110 for efficiently managing the battery.

The plurality of BMSs 110 may be provided to correspond to unit batteries provided in a hierarchical structure within the ESS. In this case, each of the plurality of BMSs 110 may include a control program for managing the status of the unit battery corresponding thereto. For example, the control program may be a software program of the BMS.

Accordingly, each of the plurality of BMSs may be operated by a control program to perform at least one of charge and discharge control, cell balancing, and status monitoring for the unit battery corresponding thereto.

According to the exemplary embodiment, the plurality of BMSs 110 may include a master BMS 111, at least one first slave BMS 112, and a second slave BMS 113, per unit battery provided in a hierarchical structure. For example, the master BMS 111 may be a Bank BMS (BBMS), which may include a control program for managing the battery status in the unit of a bank. Further, the first slave BMS 112 may be a Rack BMS (RBMS), which may include a control program for managing the battery status in the unit of a rack. Further, the second slave BMS 113 may be a Pack BMS (PBMS, or Module BMS), which may manage the battery status in the unit of a pack or a module.

The control program of each of the plurality of BMSs 110 may be continuously updated by an administrator for efficient management for each unit battery.

According to the exemplary embodiment, the master BMS 111 may be linked with an external storage device 120 via communication. For example, the master BMS 111 may be linked with the external storage device 120 by MAY communication. Accordingly, the master BMS 111 may obtain at least one control program stored on the external storage device 120 during operation of the battery system 100. Here, the external storage device 120 may be a PC of a dualized provider.

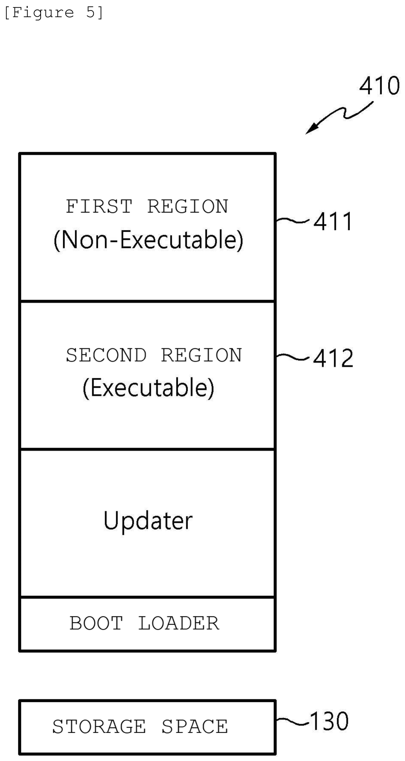

Further, the control program may be a higher version of the control program of at least one of the plurality of BMSs 110. More specifically, the master BMS 111 may store the control program in the storage space (130 in FIG. 5). Here, the storage space 130 may include an external memory that is connected to a corresponding BMS among the plurality of BMSs 100. For example, the storage space 130 may be provided in the form of physical hardware, such as a Hard Disk Drive (HDD), flash memory, EEPROM, or removable storage device.

Meanwhile, the master BMS 111 may be linked with each of the plurality of slave BMSs 112 and 113 in communication with the plurality of slave BMSs 112, 113, respectively. Accordingly, the master BMS 111 may obtain identification information of individually stored control programs from the plurality of slave BMSs 112 and 113, respectively, and manage the obtained identification information. Accordingly, the master BMS 111 may, during operation of the battery system 100, compare the identification information of the at least one control program with the identification information individually obtained from the plurality of slave BMSs 112 and 113, when the at least one control program is stored in the storage space 130. Accordingly, the master BMS 111 may identify at least one target BMS to which the at least one control program needs to be applied.

The master BMS 111 may then transmit at least one control program to the storage space 130 of the corresponding at least one target BMS. In this case, when the at least one target BMS includes a second slave BMS 113, the master BMS 111 may sequentially transmit at least one control program through a specific first slave BMS 112 that is a higher BMS of the corresponding second slave BMS 113.

Subsequently, the target BMS may execute a loader when physically connected to the storage space 130. Accordingly, the loader may copy the at least one control program stored in the storage space 130 and temporarily store the copied control program in an inactive region of the memory within the target BMS. For example, the loader may be a bootloader.

The target BMS may then delete the control program that has been pre-stored in the active region of the memory.

Thereafter, the master BMS 111 may transmit a re-execution signal to the target BMS. In response, the target BMS receiving the re-execution signal may transfer the control program temporarily stored in the inactive region to the active region in the memory.

Thereafter, the target BMS may execute the control program stored in the active region while being re-executed by the re-execution signal of the master BMS 111. Accordingly, the battery system according to the exemplary embodiment of the present invention may efficiently operate at least one battery configuring the ESS by enabling execution of the updated control program without interruption of the battery system.

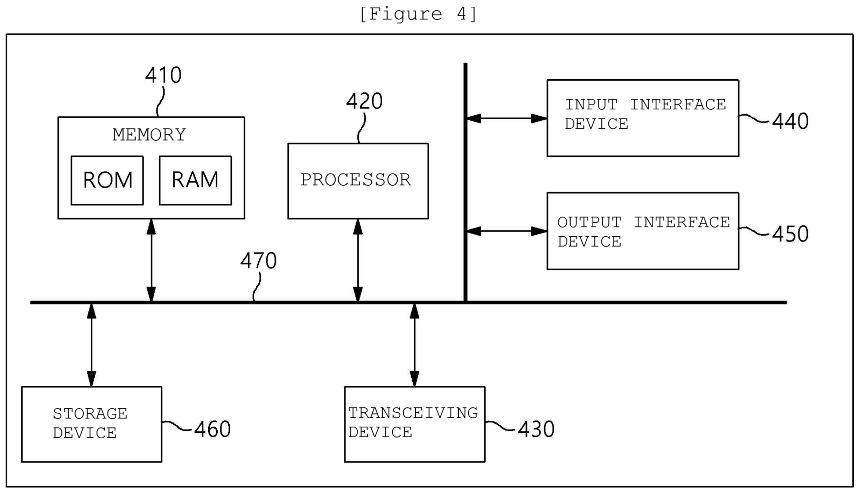

FIG. 4 is a block diagram for illustrating a hardware structure of the BMS in the battery system according to the exemplary embodiment of the present invention, and FIG. 5 is a block diagram for illustrating a memory structure of the BMS in the battery system according to the exemplary embodiment of the present invention.

Referring to FIG. 4, the plurality of BMSs 111, 112, and 113 may each include a memory 410, a processor 420, a transceiving device 430, an input interface device 440, an output interface device 450, and a storage device 460.

According to the exemplary embodiment, each of the components 410, 420, 430, 440, 450, and 460 individually included within the plurality of BMSs 110 may be connected by a bus 470 to communicate with each other.

Of the components 410, 420, 430, 440, 450, and 460, the memory 410 and the storage device 460 may be formed of at least one of a volatile storage medium and a non-volatile storage medium. For example, the memory 410 may be formed of at least one of Read Only Memory (ROM) and Random Access Memory (RAM).

Referring to FIG. 5, according to the exemplary embodiment, the memory 410 provided as a volatile storage medium may include a first region 411 and a second region 412. For example, the first region 411 may be an inactive region, which may temporarily store control programs received from the master BMS for updating. Additionally, the second region 412 may be an active region, and at least one program stored in the second region 412 may be operated by the processor 420. For example, the second region 412 may store a pre-stored control program or an updated control program from the first region 411.

According to another exemplary embodiment, the memory 410 provided as a non-volatile storage medium may include at least one program command.

In the meantime, the storage device 460 may, in some exemplary embodiments, be replaced by the storage space 130 connected to the plurality of BMSs 110.

The processor 420 may refer to a Central Processing Unit (CPU), a Graphics Processing Unit (GPU), or a dedicated processor on which the methods according to the exemplary embodiments of the present invention are performed.

The processor 420 may execute at least one program command stored in the memory 410 provided as the non-volatile storage medium.

The transceiving device 430 may provide a communication environment with the external storage device 120 and at least one of the plurality of slave BMSs 110. According to the exemplary embodiment, the transceiving device 430 may provide a wired or wireless network environment. For example, the transceiving device 430 may perform MAY communication.

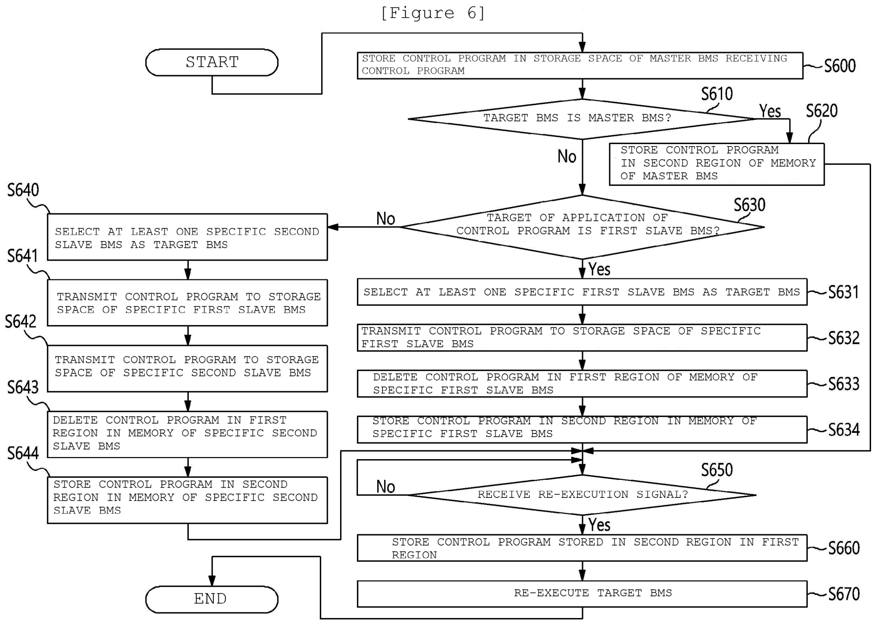

FIG. 6 is a flowchart for illustrating a method of operating a battery system according to an exemplary embodiment of the present invention.

Referring to FIG. 6, the master BMS 111 in the battery system 100 may receive at least one control program from the external storage device 120 during operation of the battery system 100. Accordingly, the master BMS 111 may store the received at least one control program in a storage space 130 (S600). Herein, the storage space 130 may be an external memory physically connected to the master BMS 111. For example, the master BMS 111 may be a Bank BMS (BBMS).

The master BMS 111 may then compare the identification information of the at least one control program stored in the storage space 130 connected with the master BMS 111 with the identification information of the plurality of BMSs 111, 112, and 113 managed by the master BMS 111 to identify the target BMS corresponding to each control program. More specifically, the identification information may include application target information and software version information. Accordingly, the master BMS 111 may extract at least one BMS corresponding to the target for application of the respective control program from the plurality of BMSs 111, 112, and 113 managed by the master BMS 111. For example, the target BMS may be any one of the master BMS 111, the first slave BMS 112, and the second slave BMS 113. Thus, the master BMS 111 may select the at least one BMS that has a lower version of the corresponding control program among the extracted at least one BMS 110 as the target BMS.

According to the exemplary embodiment, when the target BMS is the master BMS 111 (S610), the master BMS 111 may delete the BMS control program pre-stored in the first region 411 in the memory 410. The master BMS 111 may then copy the corresponding control program stored in the storage space 130 and store the copied control program in the second region 412 of the memory 410 (S620). In other words, the master BMS 111 may delete the BMS control program pre-stored in the first region 411 and download the corresponding control program stored in the storage space 130.

According to another exemplary embodiment, when the target BMS is at least one slave BMS (S610), the master BMS 111 may transmit each of the at least one control program to a specific first slave BMS 112 to which the corresponding target BMS belongs. Herein, the at least one slave BMS may include at least one of the first slave BMS 112 and the second slave BMS 113. For example, the first slave BMS 112 may be a Rack BMS (RBMS) and the second slave BMS may be a Pack (or Module) BMS (PBMS).

More specifically, when the target for application of the specific control program is at least one first slave BMS 112 (S630), the master BMS 111 may select, among the first slave BMSs 112 managed by the master BMS 111, at least one specific first slave BMS 112 having a lower version than the version information of the specific control program as the target BMS (S631). The master BMS 111 may then transmit the specific control program stored in the storage space 130 of the master BMS 111 to the storage space 130 of the at least one specific first slave BMS 112 that is the target BMS (S632).

Then, when the specific first slave BMS 112 recognizes the specific control program stored in the storage space 130 of the specific first slave BMS, the specific first slave BMS 112 may delete the BMS control program pre-stored in the first region 411 in the memory 410 of the specific first slave BMS (S633). Thereafter, the specific first slave BMS 112 may copy the specific control program pre-stored in the storage space 130 and store the copied specific control program in the second region 412 within the memory 410 (S634). In other words, the specific first slave BMS 112 may download the corresponding control program stored in the storage space 130 of the specific first slave BMS.

Here, the first region 411 may be an active region, and the second region 412 may be an inactive region.

Meanwhile, when the target for application of the specific control program is at least one second slave BMS 113 (S630), the master BMS 111 may select, among the second slave BMSs 113 managed by the master BMS 111, at least one specific second slave BMS 113 having a lower version than the version information of the specific control program as a target BMS (S640).

The master BMS 111 may transmit at least one the specific control program stored in the storage space 130 of the master BMS 111 to the storage space 130 of the specific first slave BMS 112, which is the higher BMS of each of the specific second slave BMSs 113, which is the target BMS (S641).

The specific first slave BMS 112 may then transmit the specific control program stored in the storage space 130 of the specific first slave BMS 112 to the storage space 130 of the specific second slave BMS 113 (S642) .

Thereafter, when the specific control program stored in the storage space 130 of the specific second slave BMS 113 is recognized, the specific second slave BMS 113 may delete the BMS control program pre-stored in the first region 411 within the memory 410 of the specific second slave BMS 113 (S643). Thereafter, the specific second slave BMS 113 may copy the specific control program stored in the storage space 130 of the specific second slave BMS 113 and store the copied specific control program in the second region 412 in the memory 410 of the specific second slave BMS 113 (S644). In other words, the specific second slave BMS 113 may update the program for managing the battery status by downloading the corresponding control program stored in the storage space 130 of the specific second slave BMS 113.

The master BMS 111 may then transmit the re-execution signal sequentially, based on the hierarchical structure of the at least one target BMS. For example, the master BMS 111 may receive the re-execution signal in the order of the master BMS 111, the at least one first slave BMS 112, the at least one second slave BMS 113 (S650).

The at least one target BMS receiving the re-execution signal may copy the specific control program stored in the second region 412 of the memory 410 of each of the target BMSs and store the copied specific control program in the first region 411 of the memory 410 (S660). Subsequently, upon re-execution (S670), the at least one target BMS may execute the updated control program in the first region 411, thereby updating the program of the target BMS without interrupting operation of the battery system.

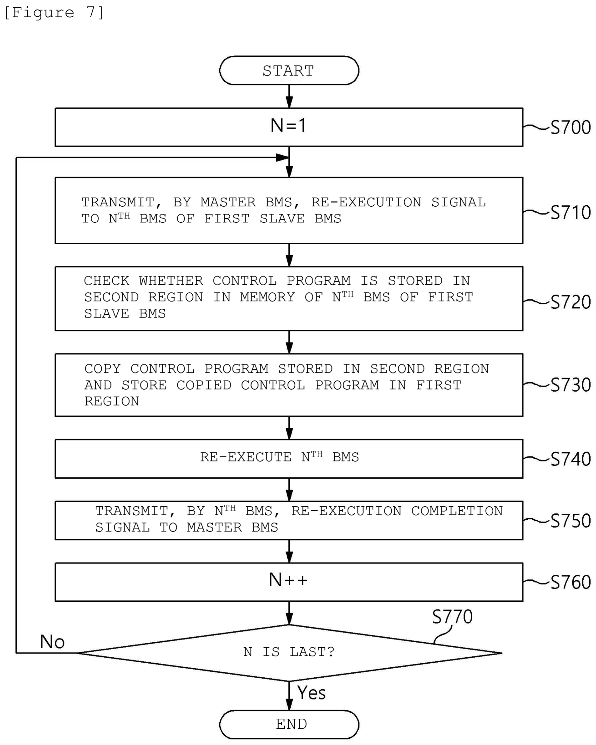

FIG. 7 is a flowchart for illustrating a method of updating the plurality of first slave BMSs in the battery system according to the exemplary embodiment of the present invention.

Referring to FIGS. 3 and 7, when the first slave BMS 112 receives the re-execution signal from the master BMS 111, the first slave BMS 112 may perform an update of the specific control program for the first BMS (BMS #1) to the N^{th} BMS (BMS #N) of the first slave BMSs 112. Herein, N is a natural number.

More specifically, when the first BMS (S700) of the first slave BMSs 112 receives the re-execution signal from the master BMS 111, that is, when the master BMS 111 transmits the re-execution signal to the first BMS (S710), the first BMS may check whether a control program is stored in the second region 412 of the memory 410 (S720). In this case, when the control program is stored in the second region 412, the first BMS may copy the control program stored in the second region 412 and store the copied control program in the first region 411 of the memory 410 (S730).

Thereafter, the first BMS may be re-executed (S740) and the control program stored in the first region 411 is activated to complete the update of the control program of the first BMS.

Thereafter, the first BMS may transmit a re-execution completion signal to the master BMS 111 (S750). In response, the master BMS 111 may transmit the re-execution signal to the second BMS of the first slave BMSs 112 (S760). Thereafter, the master BMS 111 may control operations S710 to S760 to be repeatedly performed until the N^{th} BMSs in the first slave BMS 112 (S770).

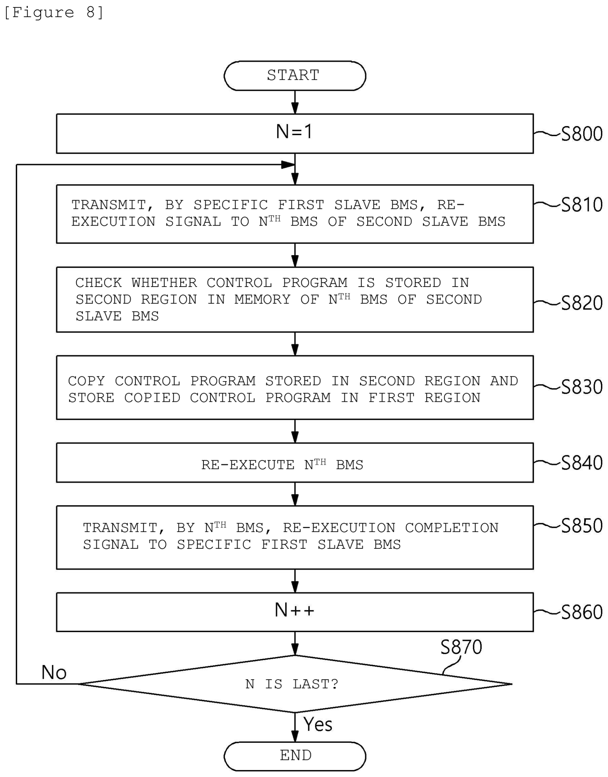

FIG. 8 is a flowchart for illustrating a method of updating the plurality of second slave BMSs in the battery system according to the exemplary embodiment of the present invention.

Referring to FIG. 8, the plurality of second slave BMSs 113 may be managed by a specific first slave BMS 112. In other words, the plurality of second slave BMSs 113 is subordinate BMSs of the specific first slave BMSs 112. Accordingly, the second slave BMS 113 may receive a re-execution signal from the specific first slave BMS 112 after operation S750 of FIG. 7. Accordingly, the second slave BMS 113 may perform an update of the specific control program, targeting the first BMS to the N^{th} BMS of the second slave BMSs 113.

More specifically, when the first BMS (S800) of the second slave BMSs 113 receives the re-execution signal from the master BMS 111, that is, when the specific first slave BMS 1112 transmits the re-execution signal to the first BMS of the second slave BMSs 113 (S810), the first BMS may check whether a control program is stored in the second region 412 of the memory 410 (S820). In this case, when the control program is stored in the second region 412, the first BMS may copy the control program stored in the second region 412 and store the copied control program in the first region 411 of the memory 410 (S830).

Thereafter, the first BMS may be re-executed (S840) and the control program stored in the first region 411 is activated to complete the update of the control program of the first BMS.

Thereafter, the first BMS may transmit a re-execution completion signal to the specific first slave BMS 112 (S850). In response, the specific first slave BMS 112 may transmit the re-execution signal to the second BMS of the second slave BMSs 113 (S860). Thereafter, the specific first slave BMS 112 may control operations S810 to S860 to be repeatedly performed until the N^{th} BMSs in the plurality of second slave BMSs 113 (S870).

Then, when the update of the control program to the N^{th} BMS of the second slave BMS is completed, the specific first slave BMS 112 may perform operation S760 of FIG. 7 to continue updating the control program of the first slave BMS 112.

The above describes the battery system and the method of operating the same according to the exemplary embodiments of the present invention.

According to the battery system and the method of operating the same according to the exemplary embodiments of the present invention, it is possible to achieve high-efficient battery management operation by updating a control program of a Battery Management System (BMS) without interrupting monitoring of a battery during operation of the battery system.

The operation of the method according to the exemplary embodiment of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

In addition, the computer-readable recording medium may include a hardware device, such as a ROM, a RAM, and a flash memory, specially configured to store and execute program commands. The program commands may include not only machine language codes such as those generated by a compiler, but also high-level language codes that may be executed by a computer by using an interpreter or the like.

Although some aspects of the invention have been described in the context of the apparatus, it may also represent a description according to a corresponding method, wherein a block or apparatus corresponds to a method operation or feature of a method operation. Similarly, aspects described in the context of a method may also represent a feature of a corresponding block or item or a corresponding apparatus. Some or all of the method operations may be performed by (or using) a hardware device, such as, for example, a microprocessor, a programmable computer, or an electronic circuit. In some exemplary embodiments, one or more of the most important method operations may be performed by such an apparatus.

While the present invention has been described above with reference to the preferred exemplary embodiments of the invention, it will be understood by those skilled in the art that various modifications and changes may be made to the invention without departing from the spirit and scope of the invention as described in the following patent claims.

## Claims

1. A battery system including a plurality of BMSs with a hierarchical structure, the battery system comprising:
a plurality of slave BMSs; and
a master BMS linked with the plurality of slave BMSs,
wherein, during operation of the battery system, the master BMS identifies a target for application of an externally inputted control program for battery management, and transmits a control program corresponding to the target for application to the target for application.

2. The battery system of claim 1, wherein when the control program is a control program applied to a slave BMS, the master BMS compares version information of each of the plurality of slave BMSs with version information of the control program, and
determines a specific slave BMS having a lower version than the version information of the control program as the target for application, and transmits the control program to the target for application.

3. The battery system of claim 2, wherein the master BMS transmits the control program to a storage space of the target for application.

4. The battery system of claim 2, wherein the specific slave BMS deletes a control program pre-stored in a first region of a memory of the specific slave BMS, and copies a control program stored in a storage space of the specific slave BMS and stores the copied control program in a second region of the memory.

5. The battery system of claim 4, wherein when a re-execution signal is received from the master BMS, the specific slave BMS copies the control program stored in the second region and stores the copied control program in the first region.

6. The battery system of claim 1, wherein the plurality of slave BMSs includes at least one first slave BMS and at least one second slave BMS having a hierarchical structure, and
wherein the second slave BMS is a sub-hierarchy of the first slave BMS.

7. The battery system of claim 6, wherein when the control program is a control program applied to the second slave BMS, the master BMS transmits a control program of the second slave BMS to a storage space of the first slave BMS, and
the first slave BMS transmits the control program of the second slave BMS, which has been transmitted to the storage space of the first slave BMS, to a storage space of the second slave BMS.

8. The battery system of claim 6, wherein when the control program is a control program applied to the second slave BMS, the master BMS compares version information of at least one control program individually received from the plurality of second slave BMSs with version information of the at least one control program, and
determines a specific second slave BMS having a lower version than the version information of the control program as the target for application, and transmits the at least one control program to a storage space of the target for application.

9. The battery system of claim 7, wherein the second slave BMS deletes a control program pre-stored in a first region of a memory of the second slave BMS, copies a control program stored in the storage space of the second slave BMS, and stores the copied control program in a second region of the memory.

10. The battery system of claim 9, wherein when a re-execution signal is received from the master BMS, the second slave BMS copies the control program stored in the second region and stores the copied control program in the first region.

11. The battery system of any one of claim 2 and claim 8, wherein the storage space includes an external memory.

12. The battery system of any one of claim 4 and claim 9, wherein the first region is an inactive region, and the second region is an active region.

13. A method of operating a battery system including a plurality of BMSs with a hierarchical structure, the method comprising:
obtaining, by a master BMS, an externally inputted control program for battery management during operation of the battery system;
identifying, by the master BMS, each target for application of the control program; and
transmitting, by the master BMS, a control program corresponding to the target for application to the target for application.

14. The method of claim 13, wherein the identifying of, by the master BMS, each target for application of the control program includes:
when the control program is a control program applied to a slave BMS, comparing, by the master BMS, version information of each of a plurality of slave BMSs linked with the master BMS with version information of the control program; and
determining, by the master BMS, a specific slave BMS having a lower version than the version information of the control program as the target for application.

15. The method of claim 14, wherein the transmitting of, by the master BMS, the control program corresponding to the target for application to the target for application includes transmitting, by the master BMS, the control program to a storage space of the target for application.

16. The method of claim 14, further comprising:
when a control program of the specific slave BMS is stored in the storage space, deleting, by the specific slave BMS, the control program pre-stored in a first region of a memory; and
copying, by the specific slave BMS, a control program stored in a storage space of the specific slave BMS and storing the copied control program in a second region of the memory.

17. The method of claim 16, further comprising:
receiving, by the specific slave BMS, a re-execution signal from the master BMS;
copying, by the specific slave BMS, the control program stored in the second region and storing the copied control program in the first region; and
re-executing the specific slave BMS.

18. The method of claim 14, wherein the plurality of slave BMSs includes at least one first slave BMS and at least one second slave BMS having a hierarchical structure, and
wherein the second slave BMS is a sub-hierarchy of the first slave BMS.

19. The method of claim 18, wherein the transmitting of, by the master BMS, the control program corresponding to the target for application to the target for application includes:
when the control program is a control program applied to the second slave BMS, transmitting, by the master BMS, a control program of the second slave BMS to a storage space of the first slave BMS; and
transmitting, by the first slave BMS, the control program of the second slave BMS, which has been transmitted to the storage space of the first slave BMS, to a storage space of the second slave BMS.

20. The method of claim 19, further comprising:
when the control program of the second slave BMS is stored in the storage space, deleting, by the second slave BMS, the control program pre-stored in a first region of a memory; and
copying, by the second slave BMS, the control program stored in the storage space of the second slave BMS and storing the copied control program in a second region of the memory.

21. The method of claim 20, further comprising:
when a re-execution signal is received from the master BMS, copying, by the second slave BMS, the control program stored in the second region; and
storing, by the second slave BMS, the copied control program in the first region.
